# EUROPEAN PATENT APPLICATION

(11) **EP 4 510 784 A1**
(43) Date of publication of application: **19.02.2025**
(21) Application number: 23858774.5
(22) Date of filing: 02.06.2023
(51) Int. Cl.: H05K 1/18

(54) **COMPUTING NODE AND COMPUTING APPARATUS**

(30) Priority: 30.08.2022 CN 202211049239
(71) Applicant: xFusion Digital Technologies Co., Ltd., Zhengzhou, Henan 450046 (CN)
(72) Inventor: LIU, Guoqiang, Zhengzhou, Henan 450046 (CN); JI, Zhongli, Zhengzhou, Henan 450046 (CN)
(74) Representative: MERH-IP Matias Erny Reichl Hoffmann Patentanwälte PartG mbB
(86) International application number: PCT/CN2023/098055
(87) International publication number: WO 2024/045735

(57) **Abstract**

Embodiments of this application provide a computing node and a computing device. The computing node includes a mainboard and a current guiding structure. An electronic component is mounted on a first surface of the mainboard, a through-current hole is disposed in a thickness direction of the mainboard, a hole wall of the through-current hole has a conductive medium, and the through-current hole is electrically connected to the electronic component. The current guiding structure is configured to be connected to a power supply, and is configured to transmit a power supply current output from the power supply, and the current guiding structure is disposed on a side of the mainboard, and is electrically connected to the hole wall of the through-current hole, to transmit the power supply current to the through-current hole in the thickness direction of the mainboard. In this application, because the current guiding structure and the mainboard are structures independent of each other, there is no limitation due to a through-current capability of the mainboard, thereby improving a power supply density of the computing node, and facilitating development of the computing node towards high-density computing power and high-density power.

## Description

This application claims priority to Chinese Patent Application No. 202211049239.9, filed with the China National Intellectual Property Administration on August 30, 2022 and entitled "COMPUTING NODE AND COMPUTING DEVICE", which is incorporated herein by reference in its entirety.

### TECHNICAL FIELD

Embodiments of this application relate to the field of computing devices, and in particular, to a computing node and a computing device.

### BACKGROUND

With the rise of big data, cloud computing, and AI (Artificial intelligence, artificial intelligence), quantities of processing cores, quantities of chips, and capacities of a processor, a memory module, and a hard disk continuously increase, and system power consumption also greatly increases (power consumption of a single processor evolves from 200 w to 1000 w). Therefore, a requirement for power supply capabilities of a data center and a server is increasingly high. However, due to a limitation of a current conventional horizontal power supply architecture, a through-current density is low, and energy efficiency is poor. As a result, it is difficult to meet a long-term evolution development requirement of power of the server.

### SUMMARY

Embodiments of this application aim to improve a power supply density of a mainboard in a computing node.

A first aspect of the embodiments of this application provides a computing node. The computing node includes a mainboard and a current guiding structure. An electronic component is mounted on a first surface of the mainboard, a through-current hole is disposed in a thickness direction of the mainboard, a hole wall of the through-current hole has a conductive medium, and the through-current hole is electrically connected to the electronic component. The current guiding structure is configured to be connected to a power supply, and is configured to transmit a power supply current output from the power supply, and the current guiding structure is disposed on a side of the mainboard, and is electrically connected to the hole wall of the through-current hole, to transmit the power supply current to the through-current hole in the thickness direction of the mainboard.

Herein, there are one or more electronic components on the mainboard, and the one or more electronic components may include one or more processors. The electronic component may further include a memory. The current guiding structure may be fixedly connected to the hole wall of the through-current hole by a conductive fastener.

In the first aspect, in a process of supplying power to the electronic component on the mainboard, the power supply current is first conducted outside the mainboard through the current guiding structure, and enters the mainboard by an electrical connection portion between the current guiding structure and the through-current hole on the mainboard. In the mainboard, the power supply current is transmitted along the through-current hole in the thickness direction of the mainboard, to reach a power supply end of the electronic component, thereby supplying power to the electronic component. In this embodiment of this application, because the current guiding structure and the mainboard are structures independent of each other, a current guiding structure with a proper through-current capability may be selected and disposed based on power required by the mainboard to which power is to be supplied, and there is no limitation due to a through-current capability of the mainboard, thereby improving a power supply density of the computing node, and facilitating development of the computing node towards high-density computing power and high-density power. In addition, because a high current does not need to flow horizontally in the mainboard, heat generated by the mainboard is greatly reduced, and working safety of the computing node is improved.

In a possible implementation of the first aspect, the mainboard includes a current carrying layer extending in a cross-sectional direction of the mainboard, and the current carrying layer is electrically connected to the hole wall of the through-current hole; and that the through-current hole is electrically connected to the electronic component includes: the through-current hole is electrically connected to at least one electronic component by the current carrying layer.

In this implementation, the current carrying layer is in contact with the hole wall of the through-current hole to implement an electrical connection. The current carrying layer may be electrically connected to the electronic component by a via hole. Therefore, the power supply current is transmitted to the current carrying layer along the through-current hole. At the current carrying layer, the power supply current can be transmitted in the cross-sectional direction of the mainboard, and then is transmitted to the power supply end of the electronic component in the thickness direction of the mainboard by the via hole.

In a possible implementation of the first aspect, a plurality of through-current holes include a first through-current hole, and the first through-current hole runs through the mainboard in the thickness direction of the mainboard; and a hole wall of the first through-current hole is in contact with the current carrying layer, to implement an electrical connection.

The first through-current hole may be fixedly connected to the current guiding structure by a conductive fastener, to ensure structural stability of the current guiding structure and the mainboard. In addition, because the conductive fastener passes through the first through-current hole, a through-current capacity of a current in the first through-current hole is improved, and a vertical through-current capability of the mainboard is improved.

In a possible implementation of the first aspect, the electronic component includes a processor module, there are a plurality of through-current holes, the plurality of through-current holes include a second through-current hole, and the mainboard further includes a high-conductivity part; the second through-current hole extends in the thickness direction of the mainboard, a first opening of the second through-current hole is configured to be connected to the current guiding structure, and a second opening of the second through-current hole is connected to the high-conductivity part; and the high-conductivity part extends from the second opening to the first surface of the mainboard in the thickness direction of the mainboard, and is in contact with a power supply end of the processor module. Herein, the first opening may be connected to the current guiding structure by a conductive fastener.

In the second through-current hole, the conductive fastener and a hole wall of the second through-current hole jointly perform conduction, to ensure a large vertical through-current capability. Further, the high-conductivity part is set to be connected between the second through-current hole and the processor module, so that a current is directly and stably transmitted to a surface of the mainboard, so as to be connected to the processor module. Therefore, there is no need to depend on another layer structure in the mainboard to perform current carrying, thereby improving reliability and stability of supplying power to the processor.

In a possible implementation of the first aspect, a cross-sectional area of the high-conductivity part is greater than or equal to a cross-sectional area of the second through-current hole.

In this possible implementation, the vertical through-current capability of the mainboard may be improved, to meet a power supply need of the processor for a high current.

In a possible implementation of the first aspect, a cross-sectional area of the high-conductivity part gradually expands in a direction from the second opening of the second through-current hole to the first surface of the mainboard.

In this possible implementation, a shape of the high-conductivity part is set, so that internal resistance of the high-conductivity part can be reduced, and generated heat can be reduced. In addition, a shape and an area of the high-conductivity part that are exposed to the first surface of the mainboard may be adjusted, to adapt to a power supply end of a switch component.

In a possible implementation of the first aspect, the second opening of the second through-current hole and the high-conductivity part are connected to each other at a first location of the current carrying layer; and the first location of the current carrying layer is further electrically connected to at least one through-current hole.

In this possible implementation, because the high-conductivity part is electrically connected to both the second through-current hole and the first through-current hole, currents in both the second through-current hole and the first through-current hole may be obtained to supply power to the processor, thereby reducing a current carrying pressure on the second through-current hole and ensuring stable power supply to the processor. In addition, the mainboard is prevented from being locally deformed because heat generated in the second through-current hole is concentrated due to a large current carrying capacity. Further, when current carrying is unstable because the second through-current hole is unstably connected to the current guiding structure, the processor may obtain a current by the first through-current hole, to ensure stable power supply.

In a possible implementation of the first aspect, the current carrying layer includes a plurality of first conductive layers, and the first conductive layers are configured to conduct the power supply current; and the plurality of first conductive layers are arranged in the cross-sectional direction of the mainboard, the plurality of first conductive layers are disposed at intervals, and each of the first conductive layers is electrically connected to at least one of the through-current holes.

In this possible implementation, because the current guiding structure may be connected to the mainboard by a plurality of points, the first conductive layer may be disposed locally and in blocks, to form a plurality of first conductive layers. Therefore, while power is supplied to the electronic component on the mainboard, an amount of copper laid between board layers of the mainboard is effectively reduced, a flow path of a current within the board layers of the mainboard is shortened, and a flow area thereof is reduced, so that heat generated by the mainboard can be reduced, and working safety and stability of the mainboard can be improved.

In a possible implementation of the first aspect, the current carrying layer includes one first conductive layer, and an area of the first conductive layer is less than a cross-sectional area of the mainboard; and the first conductive layer is electrically connected to the through-current hole.

In this possible implementation, because power may be vertically supplied to a high-power electronic component through cooperation between the second through-current hole and the high-conductivity part, a power supply current that needs to be transmitted by the current carrying layer is reduced, so that an area of a copper layer laid at the current carrying layer can be reduced. A small area of the copper layer can reduce heat generated inside the mainboard.

In a possible implementation of the first aspect, the current carrying layer includes a first layer and a second layer that are sequentially arranged in the thickness direction of the mainboard; the first layer includes the first conductive layer, the second layer includes a second conductive layer, and the second conductive layer is electrically connected to the through-current hole; and a thickness of the second conductive layer is less than or equal to a thickness of the first conductive layer.

In this possible implementation, different electronic components may be connected to the first conductive layer at the first layer or the second conductive layer at the second layer by a via hole or a blind hole based on power supply needs of different electronic components, to obtain adapted power supply currents. The current carrying layer is layered, so that adaptability of a current carrying capability of a conductive layer to a power supply need of the electronic component on the mainboard can be improved.

In a possible implementation of the first aspect, an orthographic projection of at least one second conductive layer on the first layer at least partially overlaps the first conductive layer, and the second conductive layer whose orthographic projection partially overlaps the first conductive layer and the first conductive layer. In this case, the second conductive layer may be electrically connected to the first conductive layer in the thickness direction of the mainboard.

In this possible implementation, the current carrying layer is improved, so that the vertical through-current capability of the mainboard is improved, and stability of supplying power to a high-power component on the first surface is improved. In addition, a single conductive layer inside the mainboard is also prevented from locally overheating due to an excessively large current carrying capacity.

In a possible implementation of the first aspect, the mainboard further includes a signal layer, and the current carrying layer is disposed at a same layer as the signal layer; and the signal layer includes one or more third conductive layers, and the third conductive layer is disposed on a side of the first conductive layer or between two adjacent first conductive layers.

In this possible implementation, a power supply structure is improved, so that the first conductive layer in the current carrying layer can be locally laid. In this way, the signal layer can be disposed at a same layer as the current carrying layer, thereby reducing a thickness of the mainboard. A reduced thickness of the mainboard can facilitate welding of the electronic component and reduce board manufacturing costs.

In a possible implementation of the first aspect, the mainboard further includes a ground layer, and the ground layer is disposed at a same layer as the current carrying layer; and the ground layer includes one or more fourth conductive layers, and the fourth conductive layer is disposed on a side of the first conductive layer or between two adjacent first conductive layers.

In this possible implementation, a power supply structure is improved, so that the first conductive layer of the current carrying layer can be locally laid. In this way, the ground layer can be disposed at a same layer as the current carrying layer, thereby reducing a thickness of the mainboard. A reduced thickness of the mainboard can facilitate welding of the electronic component and reduce board manufacturing costs.

In a possible implementation of the first aspect, the mainboard has a second surface that faces away from the first surface; the mainboard includes two current carrying layers, one of the current carrying layers is close to the first surface of the mainboard, and the other of the current carrying layers is close to the second surface of the mainboard; and the mainboard further includes at least one functional inner layer, and the functional inner layer is any one or more of a signal layer, a power layer, or a ground layer. For example, the functional inner layer is a signal layer and a power layer that are disposed at a same layer.

In this possible implementation, two current carrying layers are disposed, so that bi-directional power supply can be implemented, and electronic components can be disposed on two surfaces of the mainboard. In addition, the two current carrying layers supply power together, thereby further improving the through-current capability of the mainboard.

In a possible implementation of the first aspect, the current guiding structure includes one or more current guiding strips; and the current guiding strip extends in any one of a length direction, a width direction, or a diagonal direction of the mainboard.

In this possible implementation, an extension track of the current guiding strip relative to the mainboard is adjusted, so that the current guiding strip can vertically supply power to more high-power electronic components, thereby improving power supply flexibility.

In a possible implementation of the first aspect, the current guiding structure includes a plurality of stacked current guiding sheets and an anti-corrosion layer sandwiched between two adjacent current guiding sheets.

In this possible implementation, after a current guiding sheet that is located on a surface and that is in the current guiding structure is corroded, due to isolation of the anti-corrosion layer, a spread speed of downward corrosion can be isolated or reduced, thereby reducing impact caused by corrosion on an overall through-current capability of the current guiding strip structure, and ensuring stable power supply to the mainboard. In addition, a corresponding quantity of current guiding sheets may be selected based on a required through-current capacity. Therefore, it helps match computing nodes with different through-current capacity needs, and implement compatibility with different computing nodes.

In a possible implementation of the first aspect, in a possible implementation of the first aspect, there are a plurality of mainboards, the plurality of mainboards include a first mainboard and a second mainboard, the second mainboard is located on a side of the first mainboard, and a first surface of the first mainboard and a first surface of the second mainboard face a same direction; the current guiding structure includes a first current guiding strip and a first connection strip, and the first current guiding strip is disposed on a side of the first mainboard, and is fixedly connected to a through-current hole on the first mainboard; and one end of the first connection strip is fixedly connected to the first current guiding strip, and the other end of the first connection strip is connected to a through-current hole on the second mainboard.

In this possible implementation, the current guiding structure is improved, so that power is supplied to a plurality of mainboards, thereby improving a power supply density. Because the plurality of mainboards are disposed, computing power of the computing node is improved.

In a possible implementation of the first aspect, there are a plurality of mainboards, and the plurality of mainboards include a third mainboard and a fourth mainboard; the third mainboard is disposed adjacent to the fourth mainboard, and a first surface of the third mainboard and a first surface of the fourth mainboard separately face two opposite sides; and the current guiding structure is sandwiched between the third mainboard and the fourth mainboard, and is separately fixedly connected to a through-current hole on the third mainboard and a through-current hole on the fourth mainboard.

In this possible implementation, the current guiding structure is improved, so that power is supplied to a plurality of mainboards, thereby improving a power supply density. Because the plurality of mainboards are disposed, computing power of the computing node is improved.

In a possible implementation of the first aspect, the mainboard includes a plurality of computing units, and each computing unit includes a processor, a memory module disposed on a side of the processor, and a heat sink; and the computing units are arranged in an array or sequentially arranged on the mainboard.

In this possible implementation, the current guiding structure and the mainboard structure are disposed in this embodiment of this application, so that a power supply capability is improved, and a quantity of computing units arranged on the mainboard is increased, thereby improving computing power.

In a possible implementation of the first aspect, the computing node further includes a current convergence apparatus; and the current convergence apparatus has a plurality of electric energy input parts and an electric energy output part, each electric energy input part is connected to the power supply, and the electric energy output part is connected to the current guiding structure.

In this possible implementation, the current convergence apparatus converges power supply currents output by a plurality of power modules, thereby improving a capability of outputting the power supply current, and improving a power supply density.

A second aspect of the embodiments of this application provides a computing device, where the computing device includes a housing and the computing node according to the foregoing first aspect, and the computing node is mounted in the housing.

The housing may be presented in different forms based on different types of computing devices. For example, when the computing device is of a rack type or a tower type, the housing may be a box structure. When the computing device is a blade server, the housing may be in a base form or a box form. This is not specifically limited herein.

In a possible implementation of the second aspect, the computing device further includes an immersion cabinet, and an electric energy input port, a liquid outlet, and a liquid inlet that are disposed on the immersion cabinet, a coolant is accommodated in the immersion cabinet, and the computing node is immersed in the coolant; the power supply is disposed outside the immersion cabinet, the power supply is connected to the current guiding structure by a power cable, and the electric energy input port allows the power cable to penetrate into the immersion cabinet; and the liquid outlet allows a gaseous or liquid coolant to flow out, and the cooled coolant flows back to the immersion cabinet through the liquid inlet.

In this possible implementation, the immersive liquid-cooled computing device breaks through a bottleneck of conventional intra-board power supply based on an efficient heat dissipation capability of liquid cooling and a power supply architecture with a high power supply density in this embodiment of this application, so that a plurality of processors, and auxiliary sockets, heat sinks, and memories can be disposed on the mainboard, thereby ensuring a power supply capability and stability of supplying power to a high-power component on the mainboard while improving a computing power density.

In a possible implementation of the second aspect, a plurality of parallel current guiding structures are disposed in the immersion cabinet, and each of the current guiding structures is configured to supply power to one or more mainboards; and the computing device further includes a current convergence apparatus, the current convergence apparatus is in a strip shape, and extends in an arrangement direction of the plurality of current guiding structures, and each of the current guiding structures is fixedly connected to the current convergence apparatus.

In this possible implementation, the current guiding structure may be in a strip shape. Each current guiding structure is set to supply power to one or more mainboards, thereby further improving a power supply density. A plurality of parallel current guiding structures are disposed in the immersion cabinet, so that utilization of space in the immersion cabinet is improved.

### BRIEF DESCRIPTION OF DRAWINGS

FIG. 1 is a top view of a computing node according to an embodiment of this application.
FIG. 2 is a side view of a mainboard computing node according to an embodiment of this application.
FIG. 3 is a schematic diagram of an arrangement manner of a current guiding structure relative to a mainboard according to an embodiment of this application.
FIG. 4 is a schematic diagram of another arrangement manner of a current guiding structure relative to a mainboard according to an embodiment of this application.
FIG. 5 is a schematic diagram of another arrangement manner of a current guiding structure relative to a mainboard according to an embodiment of this application.
FIG. 6 is a schematic diagram of another arrangement manner of a current guiding structure relative to a mainboard according to an embodiment of this application.
FIG. 7 is a split diagram of a partial structure of a current guiding structure according to an embodiment of this application.
FIG. 8 is a side cross-sectional view of a mainboard according to an embodiment of this application.
FIG. 9 is a side cross-sectional view of another mainboard according to an embodiment of this application.
FIG. 10 is a side cross-sectional view of still another mainboard according to an embodiment of this application.
FIG. 11 is a side view of a computing node in an architecture in which two mainboards are stacked in a same direction according to an embodiment of this application.
FIG. 12 is a side view of another computing node in an architecture in which two mainboards are stacked in a same direction according to an embodiment of this application.
FIG. 13 is a side view of another computing node in an architecture in which two mainboards are stacked in a same direction according to an embodiment of this application.
FIG. 14 is a side view of another computing node in an architecture in which mainboards are stacked in a same direction according to an embodiment of this application.
FIG. 15 is a side view of an architecture in which two mainboards are arranged back-to-back according to an embodiment of this application.
FIG. 16 is a side view of another computing node in an architecture in which two mainboards are arranged back-to-back according to an embodiment of this application.
FIG. 17 is a side view of a computing node in an architecture in which a plurality of mainboards are arranged in a same direction according to an embodiment of this application.
FIG. 18 is a schematic diagram of a connection structure between a single-phase immersive liquid-cooled computing device and an external cooling apparatus according to an embodiment of this application.
FIG. 19 is a schematic diagram of a two-phase immersive liquid-cooled computing device according to an embodiment of this application.

Reference numerals:
100: computing node;
10: mainboard; 11: electronic component; 111: processor module; 112: computing unit; 113: heat sink; 114: memory; 115: processor; 121: first surface; 122: second surface; 10a: first mainboard; 10b: second mainboard; 10c: third mainboard; 10d: fourth mainboard; 13: current carrying layer; 131: first layer; 1311: first conductive layer; 132: second layer; 1321: second conductive layer; 133: signal layer; 1331: third conductive layer; 134: ground layer; 1341: fourth conductive layer; 135: insulation layer; 14: functional inner layer; 15: through-current hole; 151: first through-current hole; 152: second through-current hole; 16: high-conductivity part; 17: conductive fastener; 181: first via hole; 182: first buried hole; 136: first location;
20: current guiding structure; 21: current guiding strip; 211: first current guiding strip; 221: first connection strip; 222: second connection strip; 212: second current guiding strip; 213: third current guiding strip; 223: third connection strip; 224: fourth connection strip; 214: fourth current guiding strip; 23: current guiding sheet; 24: anti-corrosion layer;
30: power module;
40: current convergence apparatus; 41: electric energy input part;
50: PCIE card; 60: fan; 70: hard disk backplane; 80: hard disk; 90: housing;
200: computing device; 210: immersion cabinet; 2101: electric energy input port; 2102: liquid outlet; 2103: liquid inlet; 220: cooling apparatus.

### DESCRIPTION OF EMBODIMENTS

To make a person skilled in the art better understand the technical solutions in the embodiments of this application, the following clearly describes the technical solutions in the embodiments of this application with reference to the accompanying drawings in the embodiments of this application.

It should be understood that "a plurality of" mentioned in the embodiments of this application means two or more. In descriptions of the embodiments of this application, unless otherwise specified, "/" means "or". For example, A/B may represent A or B. In this specification, "and/or" describes merely an association relationship between associated objects, and represents that three relationships may exist. For example, A and/or B may represent the following three cases: A exists alone, both A and B exist, and B exists alone. In addition, to clearly describe the technical solutions in the embodiments of this application, terms such as "first" and "second" are used to distinguish between same items or similar items that have basically the same functions or purposes. A person skilled in the art may understand that terms such as "first" and "second" do not limit a quantity or an execution sequence, and terms such as "first" and "second" do not mean being definitely different.

To further describe the principles and structures of the present invention, the embodiments of the present invention are described in detail with reference to the accompanying drawings.

As a computing power need of a computing node increases, a larger quantity and more types of processors need to be deployed on a mainboard of the computing node, for example, a CPU (Central Processing Unit, central processing unit), a TPU (Tensor Processing Unit, tensor processing unit), a GPU (Graphics Processing Unit, graphics processing unit), a DPU (Deep learning Processing Unit, deep learning processing Unit), an NPU (Neural network Processing Unit, neural network processing unit), and the like. Power of the processor continuously evolves to high power. From a physical perspective, development towards high-density computing power of a computing node also leads to an increasing arrangement density of electronic components on the mainboard, for example, emergence of a half-width computing node. Because a width of the half-width computing node is half a width of a computing node of a conventional standard size, arrangement of electronic components on a mainboard of the computing node is very dense. Development towards high-density computing power of the computing node needs to depend on stable and reliable power supply to the electronic components on the mainboard.

However, in an existing server power supply technology, a two-dimensional horizontal manner is mainly used. For example, a PSU (Power supply unit, power supply unit) of a server receives a power supply current by a connector on a mainboard, and a copper layer is disposed inside a PCB of the mainboard as a power supply plane to transmit the power supply current imported from the connector, so as to supply power to various components on the PCB. However, based on this type of power supply structure of the mainboard, when a high through-current density is required, this may be implemented merely by increasing a thickness of the copper layer or a quantity of copper layers inside the PCB of the mainboard. However, an excessively thick copper layer or an excessively large quantity of copper layers may cause difficulty in drilling and layout on the PCB, and generate much heat due to continuous conduction of a high current. Consequently, a temperature inside the mainboard is excessively high, and normal working of each electronic component is seriously affected; and even in some serious cases, accidents such as fire and explosion may further occur.

For the foregoing problems, the embodiments of this application provide a computing node. A power supply structure of a mainboard in the computing node is improved to improve a through-current capability for a power supply current, so that a power supply need for layout of a high-power component and a high-density electronic component on the mainboard can be met, and a development trend of the computing node towards continuous growth of computing power in the future is supported.

### Embodiment 1

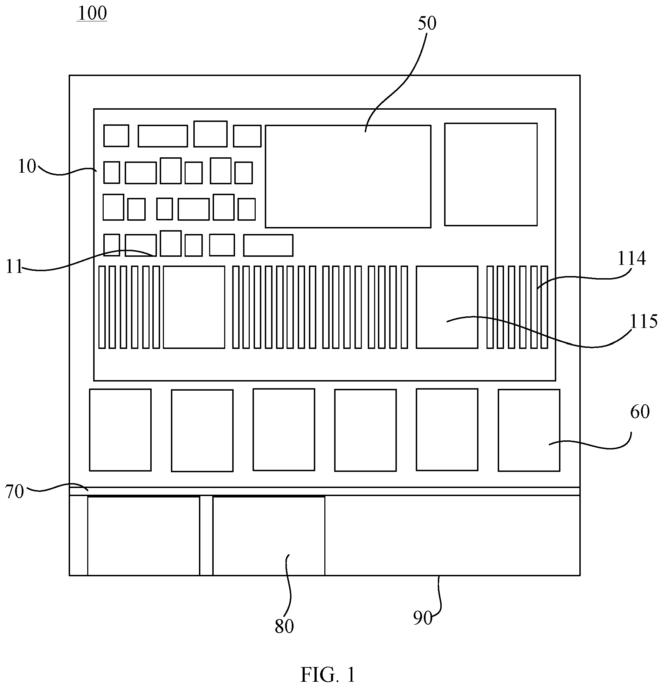

Referring to FIG. 1, FIG. 1 is a top view of a computing node 100 according to an embodiment of this application. In this embodiment, the computing node 100 includes a housing 90, and a mainboard 10, a power module 30, a current convergence apparatus 40, a current guiding structure 20, and the like that are disposed in the housing 90. The mainboard 10 includes a plurality of electronic components 11 thereon, for example, the mainboard 10 includes a processor 115, a memory 114, and the like. The processor 115 is a high-power component. A rack server is used as an example. The housing 90 may generally further include components such as a PCIE (Peripheral Component Interconnect Express, peripheral component interconnect express) card 50, a fan 60, a hard disk backplane 70, a hard disk 80, and components such as a lamp board therein.

For a blade server, a composition of the computing node 100 is different from that of the rack server. The blade server includes a base, where a plurality of single-board computers may be inserted onto the base, and the single-board computer may also be referred to as a single-board computer. When a single-board computer is considered as a computing node 100, the computing node 100 in this embodiment may not have the foregoing housing 90, and may not have foregoing components such as the power module 30, the current convergence apparatus 40, the PCIE card 50, the fan 60, the hard disk 80 backplane 70, the hard disk 80, and the lamp board.

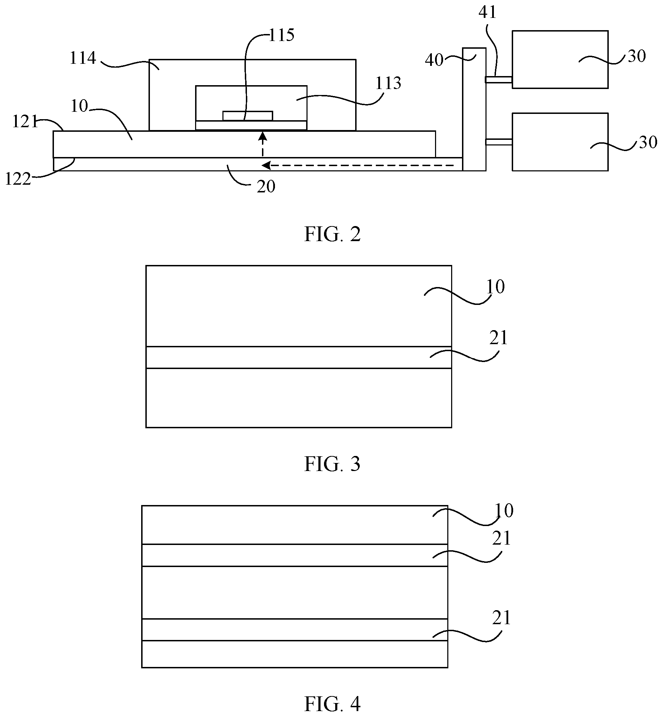

Referring to FIG. 2, FIG. 2 is a side view of a mainboard 10 computing node according to an embodiment of this application. A dashed line in FIG. 2 is used to indicate a current heat transmission path. A power supply may be the power module 30 disposed in the housing 90 of the computing node 100, or may be an external power supply disposed outside the housing 90 of the computing node 100. In an example, the power supply may include a plurality of power modules 30, and the plurality of power modules 30 are sequentially stacked or horizontally arranged in a same direction. Electric energy output by the plurality of power modules 30 may be converged by the current convergence apparatus 40, and the electric energy converged by the current convergence apparatus 40 is transmitted to the current guiding structure 20.

Specifically, the power module 30 has an electric energy output terminal, and the current convergence apparatus 40 may have a plurality of electric energy input parts 41 and an electric energy output part. Each electric energy input part 41 is connected to one power module 30, and the electric energy output part is connected to the current guiding structure 20, to converge currents output from the plurality of power modules 30. A specific structure of the current convergence apparatus 40 is not limited herein.

In an example, the current convergence apparatus 40 includes a busbar, and the busbar is made of conductive metal, for example, copper or aluminum. The current convergence apparatus 40 may be specifically in a strip structure, and an extension direction thereof is approximately the same as an arrangement direction of the plurality of power modules 30. When locations of the plurality of power modules 30 are dispersed, one or more bends are disposed on the current convergence apparatus 40 to match the arrangement locations of the plurality of power modules 30, thereby shortening a connection path to each power module 30.

The current convergence apparatus 40 may further include an overcurrent protector. When a current on the current guiding structure 20 or the current convergence apparatus 40 exceeds a threshold, the overcurrent protector acts to cut off an electrical connection between the current convergence apparatus 40 and the current guiding structure 20, so as to protect the electronic components 11 on the mainboard 10 from overcurrent impact.

In this embodiment, the current convergence apparatus 40 converges currents of the plurality of power modules 30, so that a current output capability is improved. This helps supply power to the mainboard 10 with a high power density/high-density computing power, and helps simultaneously supply power to a plurality of mainboards 10.

Herein, an orientation shown in FIG. 2 is used as a reference. Upper and lower surfaces of the mainboard 10 are respectively a first surface 121 and a second surface 122. The processor 115 and another electronic component are disposed on the first surface 121. Certainly, the processor 115 and another electronic component may be disposed on both the first surface 121 and the second surface 122. The current guiding structure 20 is connected between the current convergence apparatus 40 and the mainboard 10, and is configured to transmit, to the mainboard 10, electric energy output by the current convergence apparatus 40, to supply power to the electronic component 11 on the mainboard 10.

It should be noted that the current guiding structure 20 is generally disposed in pairs, where one current guiding structure 20 is connected to a positive electrode of the electric energy output part of the current convergence apparatus 40, and is configured to output a current, and the other current guiding structure 20 (not shown) is connected to a negative electrode of the electric energy output part of the current convergence apparatus 40, and is configured for current return. Structures and forms of the two current guiding structures 20 may be the same, and are not distinguished in the following descriptions of the embodiments.

The current guiding structure 20 is disposed on a side of the mainboard 10, and is approximately disposed in an extension direction of a surface of the mainboard 10. Herein, "a side" means that the current guiding structure 20 may be located on a side on which the first surface 121 of the mainboard 10 is located, or may be located on a side on which the second surface 122 of the mainboard 10 is located. For example, the current guiding structure 20 is located on the side on which the second surface 122 of the mainboard 10 is located, and may be attached to the second surface 122 of the mainboard 10, or there may be a gap between the current guiding structure 20 and the second surface 122 of the mainboard 10. In a process of supplying power to the electronic component 11 on the mainboard 10, a power supply current is first conducted outside the mainboard 10 through the current guiding structure 20, and enters the mainboard 10 by an electrical connection portion between the current guiding structure 20 and the second surface 122 of the mainboard 10. For example, the power supply current is first conducted outside the mainboard 10 through the current guiding structure 20, and enters the mainboard 10 in a direction approximately perpendicular to the surface of the mainboard 10 by the electrical connection portion between the current guiding structure 20 and the second surface 122 of the mainboard 10. In the mainboard 10, the power supply current may be approximately transmitted upward in a thickness direction of the mainboard 10, to reach a power supply end of the electronic component 11.

Herein, a transmission path of the power supply current in the mainboard 10 may include a transmission path on which the current is transmitted in the thickness direction of the mainboard 10, to supply power to the electronic component 11 to which power is to be supplied. The transmission path of the power supply current in the mainboard 10 may further include a transmission path in a cross-sectional direction of the mainboard 10. For example, after the power supply current enters the mainboard 10 in the thickness direction of the mainboard 10, the current is horizontally transmitted along the mainboard 10 to supply power to the electronic component 11.

In this embodiment, the current guiding structure 20 may include a current guiding strip 21 and/or a current guiding plate.

Referring to FIG. 3, FIG. 3 is a schematic diagram of an arrangement manner of a current guiding structure 20 relative to a mainboard 10 according to an embodiment of this application. In an implementation of the current guiding strip 21, the current guiding structure 20 includes one current guiding strip 21, and the current guiding strip 21 may extend in a length, width, or diagonal direction of the mainboard 10. Certainly, the current guiding strip 21 may extend in another direction.

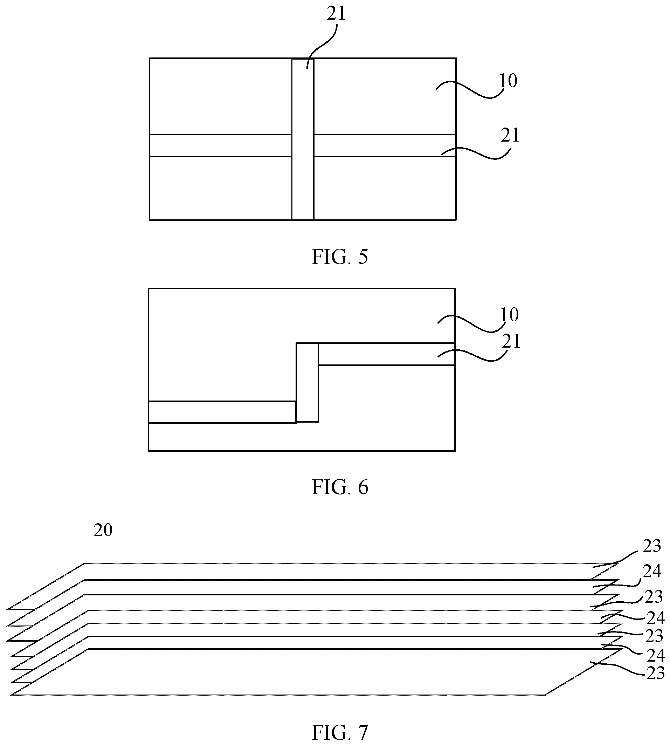

Referring to FIG. 4 and FIG. 5, FIG. 4 and FIG. 5 are schematic diagrams of another arrangement manner of a current guiding structure 20 relative to a mainboard 10 according to an embodiment of this application. In another implementation of the current guiding strip 21, there are a plurality of current guiding strips 21, and the plurality of current guiding strips 21 may be parallel, and all extend in a length, width, or diagonal direction of the mainboard 10. The plurality of current guiding strips 21 may separately extend in different directions. For example, at least one current guiding strip 21 extends in the length direction of the mainboard 10, and at least one current guiding strip 21 extends in the width direction of the mainboard 10. Through-current capabilities of the plurality of current guiding strips 21 may be different. A cross-sectional area of the current guiding strip 21 may be adjusted, so that each of the current guiding strips 21 have a different through-current capability, and correspondingly supply power to the electronic components 11 with different power classes on the mainboard 10.

Referring to FIG. 6, FIG. 6 is a schematic diagram of still another arrangement manner of a current guiding structure 20 relative to a mainboard 10 according to an embodiment of this application. In the two implementations, the current guiding strip 21 may be of a linear structure, or may have one or more bending parts based on arrangement locations of the electronic components 11 on the mainboard 10, to adjust an extension track of the current guiding strip 21 relative to the mainboard 10, so that the current guiding strip 21 can vertically supply power to more high-power electronic components.

In this embodiment, a quantity of current guiding strips 21 and an extension direction thereof may be flexibly set based on arrangement locations of the processor 115 and another high-power component on the mainboard 10, so that the current guiding strip 21 can supply power to the processor 115 and the another high-power component, to shorten a horizontal flow path of the power supply current in the mainboard 10, thereby reducing a current density in the mainboard 10, and reducing heat generated by the mainboard 10.

In an implementation of the current guiding plate, the current guiding structure 20 is in a plate shape, and is approximately parallel to the mainboard 10. An area of the current guiding structure 20 may be less than an area of the mainboard 10, or may be approximately equal to an area of the mainboard 10. The current guiding structure 20 disposed in a plate shape can greatly improve a through-current capability. In addition, the current guiding structure 20 is connected to the mainboard 10 by a plurality of points, to vertically supply power to more electronic components 11. Therefore, the horizontal flow path of the power supply current in the mainboard 10 is further shortened, and the heat generated by the mainboard 10 is greatly reduced.

It may be understood that, because the current guiding structure 20 is in a plate shape, the current guiding structure 20 may be vertically connected to more high-power components on the mainboard 10, to directly transmit a current to these high-power components, and effectively shorten the horizontal flow path of the power supply current in the mainboard 10, thereby reducing a current density in the mainboard 10, and reducing heat generated by the mainboard 10.

In the solution of this embodiment, the power supply current output from the current convergence apparatus 40 is conducted to the mainboard 10 by the current guiding structure 20. Because the current guiding structure 20 and the mainboard 10 are structures independent of each other, a current guiding structure 20 with a proper through-current capability may be selected and disposed based on power of the mainboard 10 to which power is to be supplied, and there is no limitation due to a through-current capability of the mainboard 10, thereby improving a power supply density of the computing node 100, and facilitating development of the computing node 100 towards high-density computing power and high-density power.

Each mainboard 10 may have one or more processors 115. Corresponding to each processor 115, a memory 114 slot and a heat sink 113 packaged with the processor 115 are generally configured. The mainboard 10 may further include a chipset, a PCIE slot, various ports, and the like. A type of the processor 115 on the mainboard 10 is not limited herein, and the plurality of processors 115 may be of a same type or different types.

Herein, one processor 115, and a memory 114 slot and a heat sink 113 of the processor 115 may form one computing unit. Therefore, the mainboard 10 may have one or more computing units. A plurality of computing units may be arranged in an array, or may be arranged in a single-row spaced manner, or may be irregularly arranged. Power may be vertically supplied to a processor 115 in each computing unit by the current guiding structure 20 in this embodiment, thereby improving power supply stability.

Because the electronic components 11 in the computing node 100 are densely laid out and have a large power density, much heat is generated inside the computing node 100. In addition, because the current guiding structure 20 may simultaneously supply power to a plurality of mainboards 10, a through-current capacity is large, resulting in a correspondingly much heat generation. When space permits, a gap may be disposed between the current guiding structure 20 and the mainboard 10 to which power is supplied. An air-cooled computing node includes a fan 60, and the fan 60 takes away heat in the computing node 100 by blowing air. Therefore, air can be circulated by disposing the gap between the current guiding structure 20 and the mainboard 10 to which power is supplied, to better dissipate heat for the current guiding structure 20 and the mainboard 10. For a liquid-cooled computing node 100, the gap may be disposed, so that a liquid-cooled working medium flows, thereby taking away heat from the current guiding structure 20 and the mainboard 10.

When the current guiding structure 20 is attached to the mainboard 10 to which power is supplied or the gap between the current guiding structure 20 and the mainboard 10 to which power is supplied is very small, a heat insulation layer may be disposed between the current guiding structure 20 and the mainboard 10 to which power is supplied, to reduce heat conducted from the current guiding structure 20 to the mainboard 10 to which power is supplied.

As described above, in this embodiment, the current guiding structure 20 is independent of the mainboard 10. When the current guiding structure 20 is directly exposed to an environment, for the air-cooled computing node 100, the current guiding structure 20 may be at risk of being corroded by moisture, oxygen, and another corrosive medium in the air, and consequently a through-current capability is affected.

Referring to FIG.7, FIG. 7 is a split diagram of a partial structure of a current guiding structure 20 according to an embodiment of this application. To resolve this problem, in this embodiment, the current guiding structure 20 may be set to include a plurality of stacked current guiding sheets 23. The plurality of current guiding sheets 23 may be welded at ends to implement a fixed connection and an electrical connection, or a metal conductive column may run through these current guiding sheets 23, to implement a fixed connection and an electrical connection. Each of the current guiding sheets 23 may be isolated from each other by an anti-corrosion layer 24.

The anti-corrosion layer 24 may be a separate layer, and is sandwiched between two adjacent current guiding sheets 23, or may be a coating coated on a surface of each current guiding sheet 23. A material of the anti-corrosion layer 24 may be specifically a polymer material such as acrylic acid, polyurethane, or an epoxy system, or may be a film structure made of metal tin and zinc. After a current guiding sheet 23 that is located on a surface and that is in the current guiding structure 20 is corroded, due to isolation of the anti-corrosion layer 24, a spread speed of downward corrosion can be isolated or reduced, thereby reducing impact caused by corrosion on an overall through-current capability of the current guiding strip 21 structure, and ensuring stable power supply to the mainboard 10. In addition, a corresponding quantity of current guiding sheets 23 may be selected based on a required through-current capacity. Therefore, it helps match computing nodes 100 with different through-current capacity needs, and implement compatibility with different computing nodes 100.

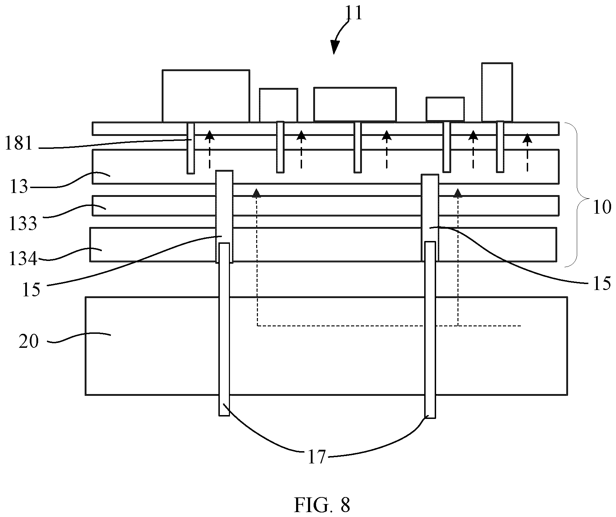

Referring to FIG. 8, FIG. 8 is a side cross-sectional view of a mainboard according to an embodiment of this application. A dashed line in FIG. 8 shows a current transmission direction. In this embodiment, the mainboard 10 includes a through-current hole 15 that extends in the thickness direction of the mainboard 10, and a current carrying layer 13, a signal layer 133, a functional inner layer 14, a ground layer 134, and the like that are disposed in the cross-sectional direction of the mainboard 10. The through-current hole 15 may cooperate with a conductive fastener 17, to implement a connection between the current guiding structure 20 and the mainboard 10. The current carrying layer 13 is configured to provide a flow path for the power supply current for conduction in the cross-sectional direction of the mainboard 10. The current carrying layer 13 is electrically connected to a hole wall of the through-current hole 15, so that the power supply current can be obtained from the through-current hole 15, and an electronic component 11 disposed along an extension path of the current carrying layer 13 can obtain the power supply current from the inside of the current carrying layer 13 by a first via hole 181.

Specifically, the through-current hole 15 is configured to implement a connection between the current guiding structure 20 and the mainboard 10. A conductive medium is coated on the hole wall of the through-current hole 15, and the conductive medium herein may be copper or aluminum. An extension direction of the through-current hole 15 is approximately the thickness direction of the mainboard 10. The current guiding structure 20 is fixedly connected to the through-current hole 15 by the conductive fastener, and is electrically connected to the through-current hole 15 while the current guiding structure 20 is fixedly connected to the through-current hole 15. The conductive fastener herein may be a bolt or a surface mount nut. A through hole is correspondingly disposed on the current guiding structure 20, and a conductive fastener sequentially passes through the through-current hole 15 and the through hole on the current guiding structure 20, to implement a fixed connection and an electrical connection between the current guiding structure 20 and the through-current hole 15.

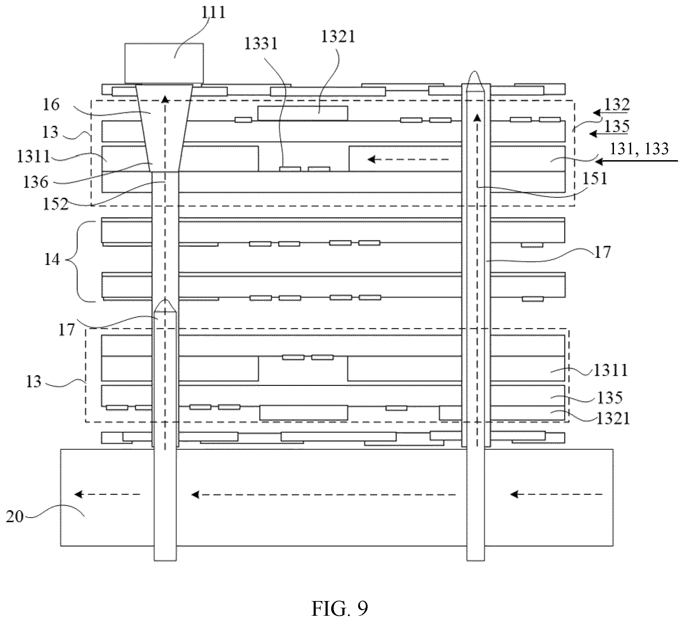

Referring to FIG. 9, FIG. 9 is a side cross-sectional view of another mainboard according to an embodiment of this application. A dashed line with an arrow shows a current transmission direction. A plurality of through-current holes 15 may be disposed, to implement multi-point vertical power supply between the current guiding structure 20 and the mainboard 10. Types of the through-current holes 15 may not be totally the same. In an implementation, the plurality of through-current holes 15 include a first through-current hole 151, and the first through-current hole 151 runs through the mainboard 10 in the thickness direction of the mainboard 10; and a hole wall of the first through-current hole 151 is in contact with the current carrying layer 13, to implement an electrical connection.

In some other implementations, the through-current hole 15 may be a blind hole. When the through-current hole 15 is a blind hole, a closed end of the through-current hole 15 is electrically connected to the current carrying layer 13 in the mainboard 10. An open end of the through-current hole 15 allows the conductive fastener 17 to pass through, to be connected to the current guiding structure 20.

The current guiding structure 20 and the through-current hole 15 are disposed, so that power can be conveniently supplied to a high-power component on the mainboard 10, without considering a setting limitation of a transmission path of a high current and a limitation of a current carrying capability of the mainboard 10. Specifically, the through-current hole 15 may be disposed close to the high-power component on the mainboard 10. For example, the through-current hole 15 may be located directly below the processor 115 or disposed corresponding to one side of the processor 115. In a power supply process, the power supply current is first transmitted outside the mainboard 10 by the current guiding structure 20, arrives at the vicinity of the processor 115 to which power is to be supplied and then enters the through-current hole 15 by the conductive fastener 17, and is directly or indirectly transmitted to a power supply end of the processor 115 in the extension direction of the through-current hole 15, thereby vertically supplying power to the processor 115. For example, when the through-current hole 15 is a blind hole, the power supply current may flow out from the through-current hole 15 and then pass through the current carrying layer 13 inside the mainboard 10, to be transmitted to a power supply end of the processor 115.

In an implementation, in a circuit design, power supply of the processor 115 is generally controlled by a switch component. Therefore, the through-current hole 15 may be electrically connected to the switch component directly or indirectly, to supply power to the processor 115 under control of the switch component. In the following examples, the processor 115 and the switch component are collectively referred to as a processor module 111.

It may be learned from the foregoing embodiments that, in this embodiment of this application, a through-current capability for a current is improved by providing the current guiding structure 20. Further, in this embodiment, based on an improvement of an internal structure of the mainboard 10, a vertical through-current capability of the mainboard 10 is improved, so that a high current transmitted on the current guiding structure 20 can be effectively transmitted to the processor 115 on the mainboard 10 stably and reliably to supply power to the processor 115.

Referring to FIG. 9, in an implementation, a vertical current carrying capability of the mainboard 10 is improved by improving the through-current hole 15. Specifically, one or more through-current holes 15 are defined on the mainboard 10, and the one or more through-current holes 15 include at least one second through-current hole 152. A first opening of the second through-current hole 152 allows the conductive fastener 17 to insert, to implement a fixed connection and an electrical connection to the current guiding structure 20. Herein, the conductive fastener 17 may be a surface mount nut. A high-conductivity part 16 is connected to a second opening of the second through-current hole 152. The high-conductivity part 16 is a solid conductive structure, extends to a top surface of the mainboard 10 in the thickness direction of the mainboard 10, and is in direct contact with a power supply end of the switch component in the processor module 111 to implement an electrical connection, thereby vertically supplying power to the processor 115.

Herein, the high-conductivity part 16 is made of a conductive material, such as copper or aluminum. In addition, a cross-sectional area of the high-conductivity part 16 is greater than or equal to a cross-sectional area of the second through-current hole 152, to improve a through-current capability, and meet a power supply need of the processor 115 for a high current.

Further, the high-conductivity part 16 may be set to gradually expand towards the first surface 121 of the mainboard 10, to gradually increase the cross-sectional area, so as to reduce internal resistance of the high-conductivity part 16, and reduce generated heat. In addition, a shape and an area of the high-conductivity part 16 that are exposed to the first surface 121 of the mainboard 10 are adjusted, to adapt to the power supply end of the switch component.

In this implementation, in the second through-current hole 152, the conductive fastener 17 and the hole wall of the second through-current hole 152 jointly perform conduction, to ensure a large vertical through-current capability. Further, the high-conductivity part 16 is set to be connected between the second through-current hole 152 and the processor module 111, so that a current is directly and stably transmitted to the surface of the mainboard 10, so as to be connected to the processor module 111. Therefore, there is no need to depend on another layer structure in the mainboard 10 to perform current carrying, thereby improving reliability and stability of supplying power to the processor 115.

Further, the second opening of the second through-current hole 152 and the high-conductivity part 16 may be set to be connected at a first location 136 of the current carrying layer 13. In addition, when the first location 136 is further electrically connected to another through-current hole 15 such as the first through-current hole 151 directly or indirectly, because the high-conductivity part 16 is electrically connected to both the second through-current hole 152 and the first through-current hole 151, currents in both the second through-current hole 152 and the first through-current hole 151 may be obtained to supply power to the processor 115, thereby reducing a current carrying pressure on the second through-current hole 152, and ensuring stable power supply to the processor 115. In addition, the mainboard 10 is prevented from being locally deformed because heat generated in the second through-current hole 152 is concentrated due to a large current carrying capacity. Further, when current carrying is unstable because the second through-current hole 152 is unstably connected to the current guiding structure 20, the processor 115 may obtain a current by the first through-current hole 151, to ensure stable power supply.

It should be understood that there are at least two central processing units 115 on the mainboard 10, and there may be another type of processor 115. In this solution, a plurality of cooperation structures between the second through-current hole 152 and the high-conductivity part 16 may be disposed, to supply power to all processors 115 in a one-to-one correspondence.

As described above, in this embodiment, in the cross-sectional direction of the mainboard 10, the mainboard 10 includes the current carrying layer 13, the signal layer 133, the functional inner layer 14, and the ground layer 134. The layers may be isolated from each other by an insulation layer. The current carrying layer 13 is in contact with the hole wall of the through-current hole 15 to implement an electrical connection. Therefore, a current transmitted from the current guiding structure 20 may be transmitted to the current carrying layer 13 by the conductive fastener 17 and the hole wall of the through-current hole 15. Because the current carrying layer 13 extends in the cross-sectional direction of the mainboard 10, the current may be transmitted in the cross-sectional direction of the mainboard 10. In addition, a via hole, a blind hole, or a buried hole may be disposed to electrically connect the current carrying layer 13 to the power supply end of the electronic component 11 on the mainboard 10, to implement a connection to the power supply end of the electronic component 11. In actual application, power may be supplied to medium and low-power electronic components 11 by the current carrying layer 13.

To meet a power supply need of the electronic component 11, the current carrying layer 13 includes a first conductive layer 1311, and the first conductive layer 1311 may be made of metal copper or aluminum. In this embodiment, copper is used as an example. The first conductive layer 1311 is a thick copper layer, and may be specifically a copper layer of 2 ounces to 4 ounces, for example, a copper layer with a thickness of 2 ounces.

Still referring to FIG. 9, in an implementation, the current carrying layer 13 includes one first conductive layer 1311, and an area of the first conductive layer 1311 is less than a cross-sectional area of the mainboard 10. Because power may be vertically supplied to the high-power electronic component through cooperation between the second through-current hole 152 and the high-conductivity part 16, a power supply current that needs to be transmitted by the current carrying layer 13 is reduced, so that an area of a copper layer laid at the current carrying layer 13 can be reduced. In this implementation, a shape of the current carrying layer 13 may be a square or an irregular shape, and a contour thereof may be designed as a straight line or a curved line based on circuit board layout.

In another implementation, because a current in the current guiding structure 20 may be conveniently guided vertically to the current carrying layer 13 by the through-current hole 15, the first conductive layer 1311 does not need to be laid at the entire current carrying layer 13. Instead, the first conductive layer may be locally laid. For example, the current carrying layer 13 includes a plurality of first conductive layers 1311, and the plurality of first conductive layers 1311 may be electrically connected to each other by a local part, or may be electrically isolated from each other. In this implementation, because the current guiding structure 20 may be connected to the mainboard 10 by a plurality of points, the first conductive layer 1311 may be disposed locally and in blocks, to form a plurality of first conductive layers 1311. Therefore, while power is supplied to the electronic component 11 on the mainboard 10, an amount of copper laid between board layers of the mainboard 10 is effectively reduced, a flow path of a current within the board layers of the mainboard 10 is shortened, and a flow area thereof is reduced, so that heat generated by the mainboard 10 can be reduced, and working safety and stability of the mainboard 10 can be improved.

In an implementation, only one current carrying layer 13 may be disposed. In another implementation, the current carrying layer includes a first layer 131 and a second layer 132 that are sequentially disposed in the thickness direction of the mainboard 10, and an insulation layer 135 sandwiched between the first layer 131 and the second layer 132. Both the first layer 131 and the second layer 132 extend in the cross-sectional direction of the mainboard 10, and are electrically connected to the hole wall of the through-current hole 15, to obtain a current transmitted from the current guiding structure 20. There is at least one first conductive layer 1311 at the first layer 131, and there is at least one second conductive layer 1321 at the second layer 132. A thickness of the second conductive layer 1321 is less than a thickness of the first conductive layer 1311. Herein, the first conductive layer 1311 and the second conductive layer 1321 may obtain currents from different through-current holes 15.

Herein, a copper layer with a thickness in a specific range may be referred to as the first conductive layer 1311. Therefore, thicknesses of a plurality of first conductive layers 1311 may be unequal. A copper layer with a thickness in another range is referred to as the second conductive layer 1321, and thicknesses of a plurality of second conductive layers 1321 may be unequal. A thickness range of the first conductive layer 1311 and a thickness range of the second conductive layer 1321 may overlap.

Current carrying capabilities of the first conductive layer 1311 and the second conductive layer 1321 are different, and power supply needs of various electronic components 11 on the mainboard 10 are also different. Therefore, different electronic components may be connected to the first conductive layer 1311 at the first layer 131 or the second conductive layer 1321 at the second layer 132 by a via hole or a blind hole based on power supply needs of different electronic components 11, to obtain adapted power supply currents. The current carrying layer 13 is layered, so that adaptability of a current carrying capability of a conductive layer to a power supply need of the electronic component 11 on the mainboard 10 can be improved.

The insulation layer 135 may be made of a wave resin material. The insulation layer 135 may block electrical interference between the first layer 131 and the second layer 132, and may support the first layer 131 or the second layer 132.

It should be understood that there may be three or more current carrying layers 13, and a conductive layer configured for power supply is disposed at each layer, so that classification can be performed based on a power supply current need of the electronic component 11 on the mainboard 10, thereby implementing hierarchical power supply to the electronic component 11.

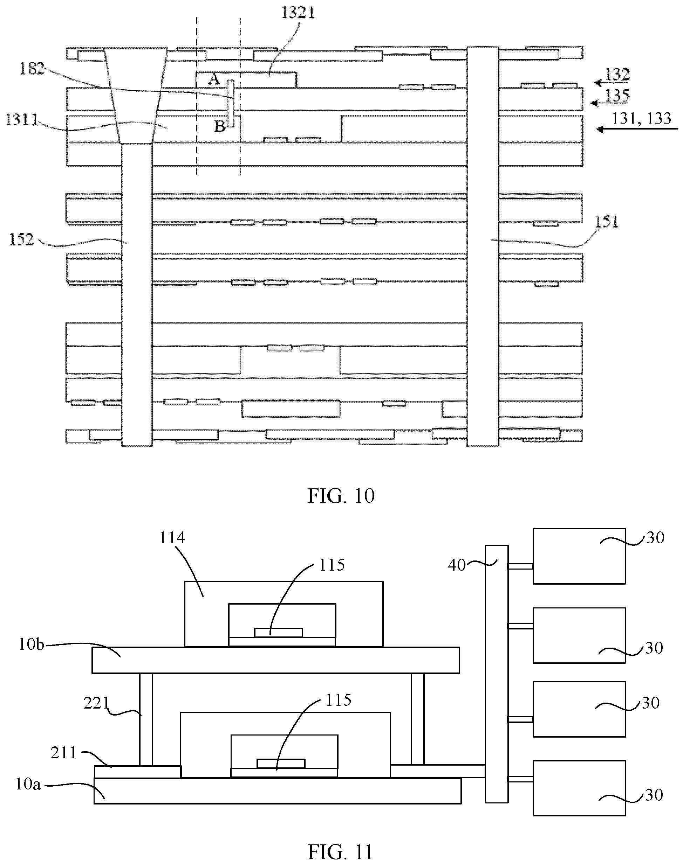

Referring to FIG. 10, FIG. 10 is a cross-sectional view of another mainboard 10 according to an embodiment of this application. Herein, the current carrying layer 13 may be further improved, to improve a vertical current carrying capability of the mainboard 10. Specifically, an orthographic projection of at least one second conductive layer 1321 at the second layer 132 on the first layer 131 may be set to at least partially overlap the first conductive layer 1311. Herein, it is assumed that a projection of a region A of the second conductive layer 1321 overlaps a region B of the first conductive layer 1311. Therefore, in a process of transmitting the power supply current to the first surface 121 of the mainboard 10, the region A and the region B may be electrically connected in the thickness direction of the mainboard 10 by a first buried hole 182 in FIG. 10, thereby improving a vertical through-current capability of the mainboard 10, improving stability of supplying power to a high-power component on the first surface 121, and preventing a single conductive layer inside the mainboard 10 from locally overheating due to an excessively large current carrying capacity. It should be understood that the first buried hole 182 may be replaced with a through hole, a blind hole, or another solid conductor structure.

The signal layer 133 is configured to transfer a signal between the electronic components 11. As described above, because a current in the current guiding structure 20 may be conveniently guided vertically to the current carrying layer 13 by the through-current hole 15, the first conductive layer 1311 does not need to be laid at the entire current carrying layer 13. Instead, the first conductive layer may be locally laid. Therefore, in an implementation, the signal layer 133 may be disposed by a region that is in the current carrying layer 13 and in which the first conductive layer 1311 is not laid. For example, the signal layer 133 is disposed at a same layer as the first layer 131, to reduce a thickness of the mainboard 10, and improve utilization of space in the mainboard 10.

When the current carrying layer 13 includes the first layer 131 and the second layer 132, the signal layer 133 may be disposed at a same layer as one of the first layer 131 or the second layer 132, or may be disposed at a same layer as both the first layer 131 and the second layer 132. It should be understood that in this case, the signal layer 133 is also correspondingly divided into two layers.

Herein, that the signal layer 133 is disposed at a same layer as the first layer 131 is used as an example. A third conductive layer 1331 configured to transfer a signal is disposed in the current carrying layer 13. The third conductive layer 1331 may also be made of metal copper or aluminum. A thickness of the third conductive layer 1331 may be less than a thickness of the first conductive layer 1311. Specifically, the third conductive layer may be copper of 0.5 ounce to 2 ounces, for example, a copper layer with a thickness of 1 ounce. A via hole, a blind hole, or a buried hole may be disposed to electrically connect the third conductive layer 1331 to the electronic component 11 on the mainboard 10, to transfer the signal between the electronic components 11.

Herein, there may be one or more third conductive layers 1331. As described above, the first conductive layer 1311 at the first layer 131 may include one or more first conductive layers 1311. When there is only one integral first conductive layer 1311 at the first layer 131, the third conductive layer 1331 may be disposed on one side of the first conductive layer 1311. When there are a plurality of first conductive layers 1311 at the first layer 131, because there may be a plurality of first conductive layers 1311, there may be one or more gaps between the plurality of first conductive layers 1311, and areas of the gaps between the plurality of first conductive layers 1311 may be unequal. Therefore, one or more third conductive layers 1331 may be laid in each of the foregoing gaps. The plurality of third conductive layers 1331 may be electrically connected to each other or electrically isolated from each other. This is specifically determined based on a layout design of the mainboard 10.

A case in which the signal layer 133 is disposed at a same layer as the second layer 132 is similar to this case. Details are not described herein again.

In an implementation in which the signal layer 133 is disposed at a same layer the current carrying layer 13, an entire copper layer or aluminum layer may be laid in the board layer in a board manufacturing process, and first conductive layers 1311 and third conductive layers 1331 with different thicknesses are manufactured through etching, thereby improving board manufacturing efficiency.

In this embodiment, a power supply structure is improved, so that the first conductive layer 1311 in the current carrying layer 13 can be locally laid. In this way, the signal layer 133 can be disposed at a same layer as the current carrying layer 13, thereby reducing a thickness of the mainboard 10. A reduced thickness of the mainboard 10 can facilitate welding of the electronic component 11 and reduce board manufacturing costs.

The ground layer 134 is configured to return, to the ground, a current returned by the electronic component 11. Referring to FIG. 9, in an implementation, the ground layer 134 and the current carrying layer 13 may be independent of each other. For example, the ground layer 134 is close to the second surface 122 of the mainboard 10, and the current carrying layer 13 is close to the first surface 121 of the mainboard 10. Distribution and a thickness of a copper layer at the ground layer 134 may be set to implement impedance matching between the ground layer 134 and the current carrying layer 13.

In another implementation, the ground layer 134 may be disposed by a region that is in the current carrying layer 13 and in which no conductive layer is laid, so that the ground layer 134 is disposed at a same layer as the current carrying layer 13. Specifically, the ground layer 134 includes a fourth conductive layer 1341, and the fourth conductive layer 1341 may also be a copper or aluminum layer. The ground layer 134 may be disposed at a same layer as one of the first layer 131 or the second layer 132, or may be disposed at a same layer as both the first layer 131 and the second layer 132.

Herein, there may be one or more fourth conductive layers 1341. As described above, there may be one or more first conductive layers 1311 at the first layer 131. When there is only one integral first conductive layer 1311 at the first layer 131, the fourth conductive layer 1341 may be disposed on one side of the first conductive layer 1311. When there are a plurality of first conductive layers 1311 at the first layer 131, because there may be a plurality of first conductive layers 1311, there may be one or more gaps between the plurality of first conductive layers 1311, and areas of the gaps between the plurality of first conductive layers 1311 may be unequal. Therefore, one or more fourth conductive layers 1341 may be laid in each of the foregoing gaps. The plurality of fourth conductive layers 1341 may be electrically connected to each other or electrically isolated from each other. This is specifically determined based on a layout design of the mainboard 10.

A case in which the ground layer 134 is disposed at a same layer as the second layer 132 is similar to this case. Details are not described herein again.

As described above, the mainboard 10 may further include one or more functional inner layers 14. The functional inner layer 14 may be a signal layer, or may be one or more of a power layer or a ground layer. Whether the functional inner layer 14 is disposed and a quantity of disposed functional inner layers may be determined based on a signal transmission quantity and a power supply need of the electronic component 11 on the mainboard 10. In some other implementations, disposition of the functional inner layer 14 is not necessary.

Based on the foregoing descriptions of the layers of the mainboard 10, it may be understood that in this embodiment, there may be one or more current carrying layers 13. In an implementation, two current carrying layer 13 may be disposed: a first current carrying layer and a second current carrying layer. The first current carrying layer may be close to the first surface 121 of the mainboard 10, and the second current carrying layer may be close to the second surface 122 of the mainboard 10. One or more functional inner layers 14 may be disposed between the first current carrying layer and the second current carrying layer. In this arrangement manner, the first current carrying layer and/or the second current carrying layer may be disposed at a same layer as the signal layer 133 and the ground layer 134.

In another implementation, the second current carrying layer may be replaced with the ground layer 134. In this case, the first current carrying layer may be disposed at a same layer only as the signal layer 133.

### Embodiment 2

The computing node 100 may have only one mainboard 10, or may have a plurality pf mainboards 10. In this embodiment, the computing node 100 includes a plurality of mainboards 10, and the plurality of mainboards 10 are stacked in a same direction. "A plurality of" herein means two or more. A stacking direction may be upward stacking, or stacking in a horizontal direction. "Same direction" means that electronic components 11 on the plurality of mainboards 10 are all disposed on the first surface 121.

Referring to FIG. 11, FIG. 11 is a side view of a computing node in an architecture in which two mainboards are stacked in a same direction according to an embodiment of this application. Specifically, the plurality of mainboards 10 include a first mainboard 10a and a second mainboard 10b, and the second mainboard 10b is located on one side of the first mainboard 10a. Herein, an upper side is used as an example. Because the electronic component 11 is disposed on the first mainboard 10a, a height of a gap between the first mainboard 10a and the second mainboard 10b is large.

When the plurality of mainboards 10 are stacked in a same direction, a structure of the current guiding structure 20 may be set based on a relative location relationship between the plurality of mainboards 10, so that electric energy is simultaneously provided to the plurality of mainboards 10, thereby improving a power supply density.

Herein, an orientation shown in FIG. 11 is used as a reference. In an implementation, the current guiding structure 20 is set to include a first current guiding strip 211 and a first connection strip 221. The first current guiding strip 211 may be disposed on the upper side of the first mainboard 10a, and a current on the first current guiding strip 211 is transmitted downward to the first mainboard 10a. One end of the first connection strip 221 is fixedly connected to the first current guiding strip 211, and the other end thereof is fixedly connected to the second mainboard 10b, to transmit a current to the second mainboard 10b and support the second mainboard 10b. The first connection strip 221 may be configured to conduct a current. In addition, the first connection strip may be configured to support the second mainboard 10b, thereby improving structural stability in the computing node 100.

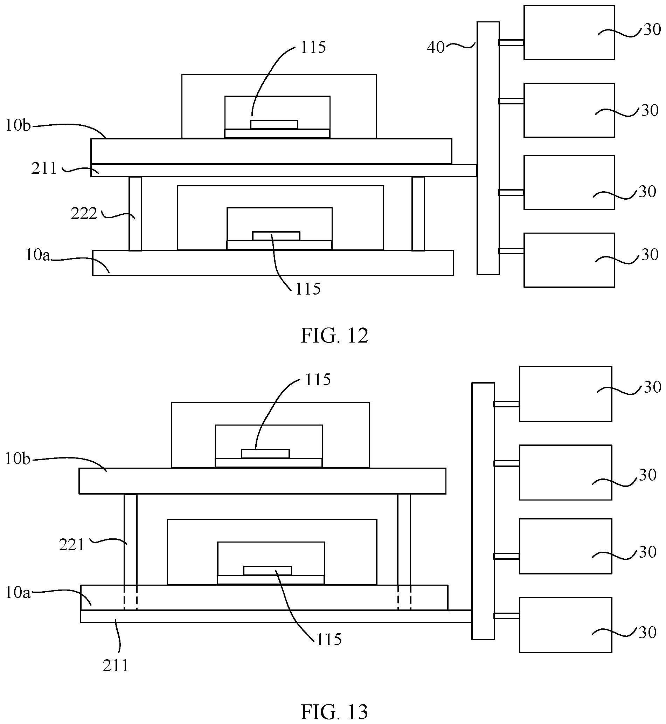

In this implementation, both the first current guiding strip 211 and the electronic component 11 on the mainboard 10 are located on a same side of the mainboard 10. Heights of components such as the processor 115 and the memory 114 on the mainboard 10 are large. Therefore, to avoid these high electronic components 11, the first current guiding strip 211 may be disposed by using any one or more of the following three solutions:
(1) The first current guiding strip 211 may be bent to change a track, thereby avoiding these high electronic components 11.
(2) A plurality of first current guiding strips 211 may be disposed. Each segment is separately connected to the power module 30 or the current convergence apparatus 40. For example, in FIG. 11, for a computing unit 112 formed by the processor 115, the memory 114, and the heat sink 113, two first current guiding strips 211 are disposed on two sides of the computing unit 112, and the two first current guiding strips 211 may be separately connected to same or different power modules 30 or current convergence apparatuses 40.
(3) A plurality of first current guiding strips 211 may be disposed. Each current guiding strip 21 is fixedly connected to the mainboard 10, and adjacent current guiding strips 21 may be electrically connected to each other by the current carrying layer 13 in the mainboard 10, to ensure continuous transmission of the power supply current.
(4) Referring to FIG. 12, a height of the first current guiding strip 211 is increased, so that the height of the first current guiding strip 211 is greater than the height of the electronic component that needs to be avoided on the mainboard 10. Then, a second connection strip 222 is set to be connected between the first current guiding strip 211 and the mainboard 10. In this implementation, the first connection strip 221 may not be disposed, and the first current guiding strip 211 is directly connected to the second mainboard 10b.

Referring to FIG. 13, in another implementation, the first current guiding strip 211 may be disposed on a lower side of the first mainboard 10a. In this case, the first connection strip 221 may be fixedly connected to the second mainboard 10b by running through the first mainboard 10a.

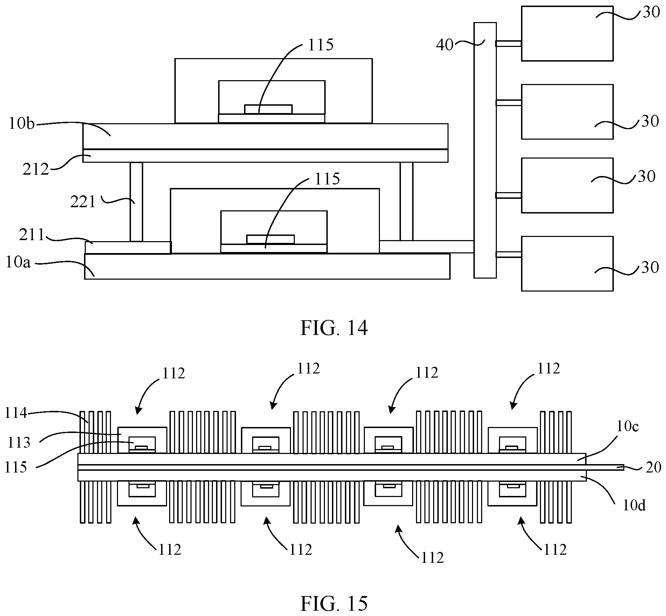

Referring to FIG. 14, the first connection strip 221 may be indirectly connected to the second mainboard 10b. For example, the second current guiding strip 212 is set to be connected to the second mainboard 10b, where the second current guiding strip 212 approximately extends along a surface of the second mainboard 10b.

It should be understood that one or more first current guiding strips 211, one or more second current guiding strips 212, and one or more first connection strips 221 may be disposed. In addition, the first connection strip 221 is set to run through the second mainboard 10b or a connection strip is added, so that more layers of mainboards 10 can be stacked on the second mainboard 10b, to improve a computing power density while meeting a power supply need.

In another implementation, the second mainboard 10b may be another type of circuit board, such as a Riser card, in the computing node 100.

In this embodiment, for structural descriptions of components such as the power module 30, the current convergence apparatus 40, the current guiding structure 20, and the mainboard 10, refer to Embodiment 1. Details are not described herein again.

### Embodiment 3

This embodiment may be applied to a computing device such as a cluster or a supercomputer. The computing node 100 includes a plurality of mainboards 10, and every two mainboards 10 in the plurality of mainboards 10 are arranged in a "back-to-back" structure. Each mainboard includes a plurality of computing units 112. The computing node 100 may include one or more structures in which the mainboards 10 are arranged "back-to-back".

Specifically, two mainboards 10 in one "back-to-back" structure include a third mainboard 10c and a fourth mainboard 10d. The third mainboard 10c and the fourth mainboard 10d may have different areas, and may also have different shapes. A first surface 121 of the third mainboard 10c and a first surface 121 of the fourth mainboard 10d respectively face two different directions.

Referring to FIG. 15, FIG. 15 is a side view of an architecture in which two mainboards are arranged back-to-back according to an embodiment of this application. Herein, an orientation shown in FIG. 15 is used as an example. The current guiding structure 20 is sandwiched between the third mainboard 10c and the fourth mainboard 10d, and the current guiding structure 20 is separately fixedly connected to the third mainboard 10c and the fourth mainboard 10d. The current guiding structure 20 supplies power to the third mainboard 10c by conducting a current upward, and supplies power to the fourth mainboard 10d by conducting a current downward.

In an implementation, when a distance between the third mainboard 10c and the fourth mainboard 10d is small, the current guiding structure 20 may include only a third current guiding strip 213.

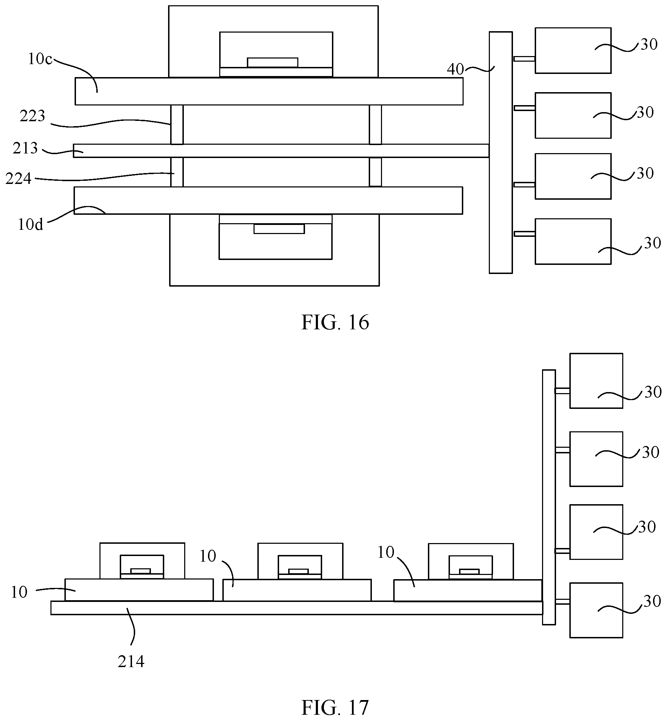

Referring to FIG. 16, FIG. 16 is a side view of another computing node in an architecture in which two mainboards are arranged back-to-back according to an embodiment of this application. In another implementation, when a distance between the third mainboard 10c and the fourth mainboard 10d is large, the current guiding structure 20 may further include a third connection strip 223 and a fourth connection strip 224. The third connection strip 223 is fixedly connected between the third current guiding strip 213 and the third mainboard 10c to transmit a current on the third current guiding strip 213 to the third mainboard 10c. The fourth connection strip 224 is fixedly connected between the third current guiding strip 213 and the fourth mainboard 10d to transmit a current on the third current guiding strip 213 to the fourth mainboard 10d. There may be one or more third current guiding strips 213, one or more third connection strips 223, and one or more fourth connection strips 223.

It should be understood that the third connection strip 223 and the fourth connection strip 224 are not necessary, and may be disposed properly based on the distance between the third mainboard 10c and the fourth mainboard 10d.

In this embodiment, the mainboards 10 are arranged "back-to-back", and the current guiding structure 20 is disposed, so that a power supply density is doubled, and PUE (Power Usage Effectiveness, power usage effectiveness) is reduced.

In this embodiment, for structural descriptions of components such as the power module 30, the current convergence apparatus 40, the current guiding structure 20, and the mainboard 10, refer to Embodiment 1. Details are not described herein again.

### Embodiment 4

Referring to FIG. 17, FIG. 17 is a side view of a computing node 100 in an architecture in which a plurality of mainboards are arranged in a same direction according to an embodiment of this application. In this embodiment, the computing node 100 includes a plurality of mainboards 10, the plurality of mainboards 10 are disposed side by side in a same direction, first surfaces 121 of the plurality of mainboards 10 face a same direction, and there may be a gap between two adjacent mainboards 10, or two adjacent mainboards may be in contact with each other. Specifically, the plurality of mainboards 10 are sequentially arranged in a horizontal direction, and the first surfaces 121 of the mainboards 10 all face upward.

Herein, an orientation in FIG. 17 is used as an example. The current guiding structure 20 may be disposed below the plurality of mainboards 10, and extends in an arrangement direction of the plurality of mainboards 10, to simultaneously supply power to the plurality of mainboards 10. Specifically, the current guiding structure 20 may include a fourth current guiding strip 214. The fourth current guiding strip 214 approximately extends in the arrangement direction of the plurality of mainboards 10, and may be directly or indirectly connected to each mainboard 10 by a connection strip, and supply power to each mainboard 10 by transmitting a current upward.

In the foregoing Embodiment 1, Embodiment 2, Embodiment 3, and Embodiment 4, some possible arrangement manners of the plurality of mainboards 10 and corresponding disposition manners of the current guiding structure 20 are described. It should be understood that, as computing power of the computing node 100 continuously increases, one computing node 100 includes a plurality of mainboards 10. Due to a condition of space in the computing node 100, the plurality of mainboards 10 may be arranged in a plurality of manners. However, both a through-current capability and an extension shape of the current guiding structure 20 may be customized. Therefore, the current guiding structure 20 may be disposed to simultaneously supply power to two or more mainboards 10, thereby improving a power supply density, meeting a power supply need of a high-power component on the mainboard 10, and improving working stability of the computing node 100.

### Embodiment 5

In this embodiment, an immersive liquid-cooled computing device 200 is provided. Immersive liquid cooling may be direct-contact liquid cooling, and is to immerse a heat-emitting electronic component 11 in a coolant, so as to lower a temperature of the electronic component 11. In immersive liquid cooling, because the heat-emitting element is in contact with the coolant, heat dissipation efficiency is higher than that in conventional heat dissipation manners, such as air cooling and water cooling, and noise is lower than that of a cold plate or spray liquid cooling.

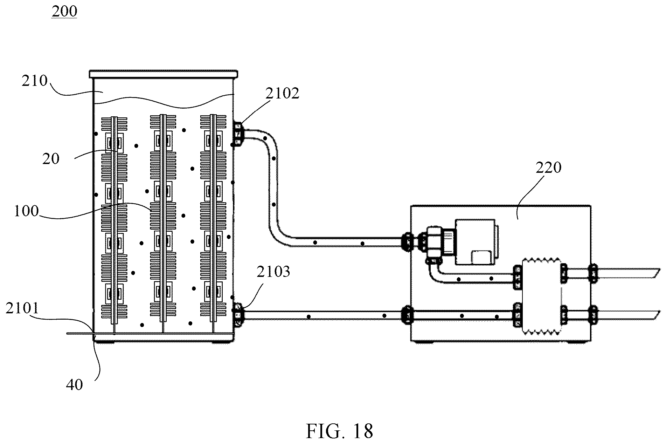

Referring to FIG. 18, FIG. 18 is a schematic diagram of a connection structure between a single-phase immersive liquid-cooled computing device and an external cooling apparatus according to an embodiment of this application. In this embodiment, the computing device 200 includes an immersion cabinet 210 and a computing node 100 disposed in the immersion cabinet 210. In some other embodiments, the computing device 200 may further include a cooling apparatus 220 disposed outside the immersion cabinet 210. For an embodiment of the computing node 100, refer to the foregoing Embodiment 1, Embodiment 2, Embodiment 3, and Embodiment 4.

As mentioned in the foregoing embodiment of the computing node 100, the computing node 100 includes a mainboard 10, a current guiding structure 20, and a current convergence apparatus 40. For a computing node 100 of a type such as a high density, a cluster, and supercomputing, the mainboard 10 may include a plurality of computing units 112, the computing unit 112 includes a processor 115 and a memory 114, and may further include a heat sink 113 encapsulated with the processor 115. The plurality of computing units 112 are arranged in an array on the mainboard 10.

The mainboard 10 in the immersion cabinet 210 may be arranged in the "back-to-back" form described in the foregoing embodiment of the computing node 100. Two mainboards 10 are disposed "back-to-back" to form a group of computing nodes 100, and each group of computing nodes 100 shares one current guiding structure 20. A plurality of groups of computing nodes 100 may be disposed in the immersion cabinet 210, and the plurality of groups of computing nodes 100 are approximately arranged in parallel. The current convergence apparatus 40 may be disposed in a strip shape, and approximately extend in an arrangement direction of the plurality of groups of computing nodes 100. The current guiding structure 20 in each group of computing nodes 100 is fixedly connected to the current convergence apparatus 40.

In some other implementations, the mainboards 10 may be disposed in the immersion cabinet 210 in a manner of "being stacked in a same direction" in the foregoing embodiment and in a manner in which the plurality of mainboards 10 are arranged in a same direction.

The power supply may be disposed outside the immersion cabinet 210, and an electric energy input port 2101 is disposed on the immersion cabinet 210. The power module 30 is connected to the current guiding structure 20 by a power cable. The electric energy input port 2101 allows the power cable to penetrate into the immersion cabinet 210. The power module 30 is connected to the current convergence apparatus 40. Sealing needs to be performed between the power cable and the electric energy input port 2101 to avoid the coolant from overflowing.

After absorbing the heat of the electronic component 11 on the mainboard 10 in the immersion cabinet 210, the coolant flows out from the liquid outlet 2102. After being cooled by the external cooling device 220, the coolant flows back to the immersion cabinet 210 through the liquid inlet 2103 in the immersion cabinet 210.

Still referring to FIG. 18, for single-phase immersive liquid cooling, the cooling apparatus 220 disposed outside the immersion cabinet 210 may include a circulation pump, a heat exchanger, and a circulation pipeline. The coolant in the immersion cabinet 210 may be electronic fluorinated liquid, but the electronic fluorinated liquid remains in a liquid state. The mainboard 10 is directly immersed in the electronic fluorinated liquid, to transfer heat from the electronic component 11 on the mainboard 10 to the coolant.

The cooling apparatus 220 may include a circulation pump and a heat exchanger. The liquid outlet 2103 on a cabinet body of the immersion cabinet 210, the circulation pump, the heat exchanger, and the liquid inlet 2102 form a circulation loop by a pipeline. The electronic fluorinated liquid with a high temperature flows out from the liquid outlet 2103, flows in the circulation loop under the power of the circulation pump, and performs heat exchange with cooling water in the heat exchanger, to form electronic fluorinated liquid with a low temperature. The electronic fluorinated liquid with a low temperature flows back to the immersion cabinet 210 through the liquid inlet 2102. Herein, the circulating cooling water in the heat exchanger may be provided by a cooling water tower and/or a dry cooler.

In this embodiment, the immersive liquid-cooled computing device 200 breaks through a bottleneck of conventional intra-board power supply based on an efficient heat dissipation capability of liquid cooling and a power supply architecture with a high power supply density in this embodiment of this application, so that at least four processors 115, and auxiliary sockets, heat sinks 113, and memories 114 can be disposed on the mainboard 10, thereby ensuring a power supply capability and stability of supplying power to a high-power component on the mainboard 10 while improving a computing power density.

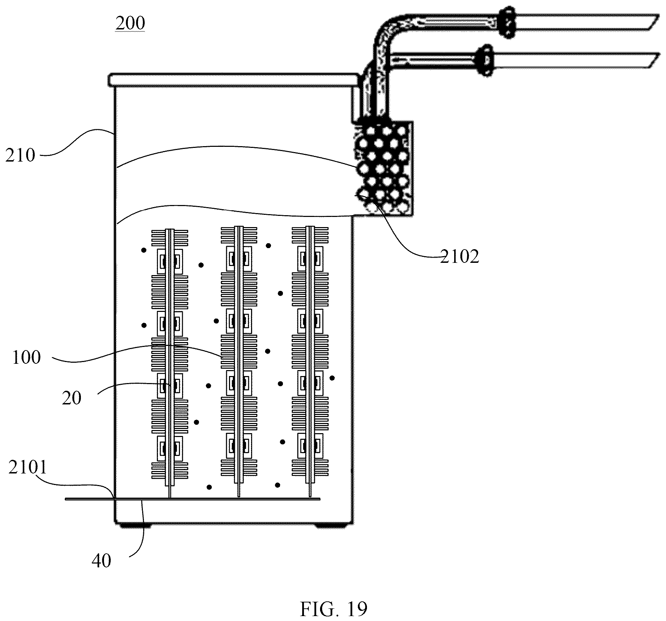

Referring to FIG. 19, FIG. 19 is a schematic diagram of a two-phase immersive liquid-cooled computing device according to an embodiment of this application. For two-phase immersive liquid cooling, the liquid inlet 2103 and the liquid outlet 2102 may be the same. The coolant in the immersion cabinet 210 may be electronic fluorinated liquid. The cooling apparatus 220 includes a condenser coil disposed outside the immersion cabinet 210 and a dry cooler. The electronic component 11 on the mainboard 10 is directly immersed in the electronic fluorinated liquid, to transfer heat from the electrical component 11 to the electronic fluorinated liquid, so that the electronic fluorinated liquid boils to generate vapor. Heat transfer efficiency is greatly improved by boiling and condensing processes of the electronic fluorinated liquid. The vapor flows out from the liquid outlet 2102 of the immersion cabinet 210 to the condensing coil, and performs, in the condensing coil, heat exchange with circulating cooling water provided by the dry cooler. After being condensed, the vapor is converted into liquid, and still flows back to the immersion cabinet 210 through the liquid outlet 2102.

Although the present invention has been described with reference to several example implementations, it should be understood that the used terms are illustrative and example instead of limiting terms. Because the present invention can be specifically implemented in various forms without departing from the spirit or essence of the present invention, it should be understood that the foregoing implementations are not limited to any of the foregoing details, but should be widely interpreted within the spirit and scope of the appended claims. Therefore, all variations and modifications falling within the claims or their equivalents should be covered by the appended claims.

## Claims

1. A computing node, comprising:
a mainboard, wherein an electronic component is mounted on a first surface of the mainboard, a through-current hole is disposed in a thickness direction of the mainboard, a hole wall of the through-current hole has a conductive medium, and the through-current hole is electrically connected to the electronic component; and
a current guiding structure, wherein the current guiding structure is configured to be connected to a power supply, and is configured to transmit a power supply current output from the power supply, and the current guiding structure is disposed on a side of the mainboard, and is electrically connected to the hole wall of the through-current hole, to transmit the power supply current to the through-current hole in the thickness direction of the mainboard.

2. The computing node according to claim 1, wherein the mainboard comprises a current carrying layer extending in a cross-sectional direction of the mainboard, and the current carrying layer is electrically connected to the hole wall of the through-current hole; and
that the through-current hole is electrically connected to the electronic component comprises: the through-current hole is electrically connected to at least one electronic component by the current carrying layer.

3. The computing node according to claim 2, wherein there are a plurality of through-current holes, the plurality of through-current holes comprise a first through-current hole, and the first through-current hole runs through the mainboard in the thickness direction of the mainboard; and
a hole wall of the first through-current hole is in contact with the current carrying layer, to implement an electrical connection.

4. The computing node according to any one of claims 1 to 3, wherein the electronic component comprises a processor module, there are a plurality of through-current holes, the plurality of through-current holes comprise a second through-current hole, and the mainboard further comprises a high-conductivity part;
the second through-current hole extends in the thickness direction of the mainboard, a first opening of the second through-current hole is configured to be connected to the current guiding structure, and a second opening of the second through-current hole is connected to the high-conductivity part; and
the high-conductivity part extends from the second opening to the first surface of the mainboard in the thickness direction of the mainboard, and is in contact with a power supply end of the processor module.

5. The computing node according to claim 4, wherein a cross-sectional area of the high-conductivity part is greater than or equal to a cross-sectional area of the second through-current hole.

6. The computing node according to claim 4, wherein a cross-sectional area of the high-conductivity part gradually expands in a direction from the second opening of the second through-current hole to the first surface of the mainboard.

7. The computing node according to claim 4, wherein the second opening of the second through-current hole and the high-conductivity part are connected to each other at a first location of the current carrying layer; and
the first location of the current carrying layer is further electrically connected to at least one through-current hole.

8. The computing node according to any one of claims 2 to 7, wherein the current carrying layer comprises a plurality of first conductive layers, and the first conductive layers are configured to conduct the power supply current; and
the plurality of first conductive layers are arranged in the cross-sectional direction of the mainboard, the plurality of first conductive layers are disposed at intervals, and each of the first conductive layers is electrically connected to at least one of the through-current holes.

9. The computing node according to claim 2, wherein the current carrying layer comprises one first conductive layer, and an area of the first conductive layer is less than a cross-sectional area of the mainboard; and
the first conductive layer is electrically connected to the through-current hole.

10. The computing node according to claim 8 or 9, wherein the current carrying layer comprises a first layer and a second layer, and the first layer and the second layer are sequentially arranged in the thickness direction of the mainboard;
the first layer comprises the first conductive layer, the second layer comprises a second conductive layer, and both the first conductive layer and the second conductive layer are electrically connected to the through-current hole; and
a thickness of the second conductive layer is less than or equal to a thickness of the first conductive layer.

11. The computing node according to claim 10, wherein there are one or more second conductive layers, an orthographic projection of at least one of the second conductive layers on the first layer at least partially overlaps the first conductive layer, and the second conductive layer whose orthographic projection partially overlaps the first conductive layer is electrically connected to the first conductive layer.

12. The computing node according to any one of claims 8 to 11, wherein the mainboard further comprises a signal layer, and the current carrying layer is disposed at a same layer as the signal layer; and
the signal layer comprises one or more third conductive layers, and the third conductive layer is disposed on a side of the first conductive layer or between two adjacent first conductive layers.

13. The computing node according to any one of claims 8 to 11, wherein the mainboard further comprises a ground layer, and the current carrying layer is disposed at a same layer as the ground layer; and
the ground layer comprises one or more fourth conductive layers, and the fourth conductive layer is disposed on a side of the first conductive layer or between two adjacent first conductive layers.

14. The computing node according to any one of claims 2 to 13, wherein the mainboard has a second surface that faces away from the first surface;
the mainboard comprises two current carrying layers, one of the current carrying layers is close to the first surface of the mainboard, and the other of the current carrying layers is close to the second surface of the mainboard; and
the mainboard further comprises at least one functional inner layer, and the functional inner layer is any one or more of a signal layer, a power layer, or a ground layer.

15. The computing node according to any one of claims 1 to 14, wherein the current guiding structure comprises one or more current guiding strips; and
the current guiding strip extends in any one of a length direction, a width direction, or a diagonal direction of the mainboard.

16. The computing node according to any one of claims 1 to 15, wherein the current guiding structure comprises a plurality of stacked current guiding sheets and an anti-corrosion layer sandwiched between two adjacent current guiding sheets.

17. The computing node according to any one of claims 1 to 16, wherein there are a plurality of mainboards, the plurality of mainboards comprise a first mainboard and a second mainboard, the second mainboard is located on a side of the first mainboard, and a first surface of the first mainboard and a first surface of the second mainboard face a same direction;
the current guiding structure comprises a first current guiding strip and a first connection strip, and the first current guiding strip is disposed on a side of the first mainboard, and is fixedly connected to a through-current hole on the first mainboard; and
one end of the first connection strip is fixedly connected to the first current guiding strip, and the other end of the first connection strip is connected to a through-current hole on the second mainboard.

18. The computing node according to any one of claims 1 to 16, wherein there are a plurality of mainboards, and the plurality of mainboards comprise a third mainboard and a fourth mainboard;
the third mainboard is disposed adjacent to the fourth mainboard, and a first surface of the third mainboard and a first surface of the fourth mainboard separately face two opposite sides; and
the current guiding structure is sandwiched between the third mainboard and the fourth mainboard, and is separately fixedly connected to a through-current hole on the third mainboard and a through-current hole on the fourth mainboard.

19. The computing node according to claim 1, wherein the mainboard comprises a plurality of computing units, and each computing unit comprises a processor, a memory module disposed on a side of the processor, and a heat sink; and
the computing units are arranged in an array or sequentially arranged on the mainboard.

20. The computing node according to claim 1, wherein the computing node further comprises a current convergence apparatus; and
the current convergence apparatus has a plurality of electric energy input parts and an electric energy output part, each electric energy input part is connected to the power supply, and the electric energy output part is connected to the current guiding structure.

21. A computing device, comprising a housing and the computing node according to any one of claims 1 to 20, wherein the computing node is mounted in the housing.

22. The computing device according to claim 21, wherein the computing device further comprises an immersion cabinet, and an electric energy input port, a liquid outlet, and a liquid inlet that are disposed on the immersion cabinet, a coolant is accommodated in the immersion cabinet, and the computing node is immersed in the coolant;
the power supply is disposed outside the immersion cabinet, the power supply is connected to the current guiding structure by a power cable, and the electric energy input port allows the power cable to penetrate into the immersion cabinet; and
the liquid outlet allows a gaseous or liquid coolant to flow out, and the cooled coolant flows back to the immersion cabinet through the liquid inlet.

23. The computing device according to claim 22, wherein the computing device comprises a plurality of parallel current guiding structures, and each of the current guiding structures is configured to supply power to one or more mainboards; and
the computing device further comprises a current convergence apparatus, the current convergence apparatus is in a strip shape, and extends in an arrangement direction of the plurality of current guiding structures, and each of the current guiding structures is fixedly connected to the current convergence apparatus.
